# EUROPÄISCHE PATENTSCHRIFT

(11) **EP 2 506 371 B1**
(45) Veröffentlichungstag und Bekanntmachung des Hinweises auf die Patenterteilung: **23.06.2021**
(21) Anmeldenummer: 12158971.7
(22) Anmeldetag: 12.03.2012
(51) Int. Cl.: H01S 5/14, H01S 5/00

(54) **Diodenlaser**
Laser diode
Laser à diodes

(30) Priorität: 28.03.2011 DE 102011006198
(43) Veröffentlichungstag der Anmeldung: 03.10.2012
(73) Patentinhaber: Ferdinand-Braun-Institut gGmbH, Leibniz-Institut für Höchstfrequenztechnik, 12489 Berlin (DE)
(72) Erfinder: Eppich, Bernd, 10997 Berlin (DE)
(74) Vertreter: Gulde & Partner

(56) Entgegenhaltungen:
- WO-A1-2008/107823
- WO-A1-2010/022925
- US-A1- 2005 248 819

## Beschreibung

Die vorliegende Erfindung betrifft einen Diodenlaser mit spektral selektiver Rückkopplung mittels eines Volumen-Bragg-Gitters, insbesondere betrifft die vorliegende Erfindung einen rauscharmen, wellenlängenstabilisierten Diodenlaser mit kollimierter Strahlung und geringem Strahldurchmesser.

Die Strahlung von kantenemittierenden Diodenlasern weist eine hohe Divergenz senkrecht zur Wellenleiterebene (vertikale Richtung, "Fast Axis") und ein vergleichsweise breites Wellenlängenspektrum auf. Das Wellenlängenspektrum hängt darüber hinaus typischerweise von weiteren Parametern, wie beispielsweise der Temperatur ab. Daraus ergibt sich in der Folge eine Abhängigkeit des Wellenlängenspektrums von der Laserleistung.

Zur Kollimation der Strahlung in vertikaler Richtung werden meist Zylinderlinsen mit kleiner Brennweite benutzt, sogenannte Fast-Axis-Kollimatoren (FACs). Der Strahldurchmesser des kollimierten Strahls ist dabei proportional zur Divergenz der den Diodenlaser verlassenden Strahlung und zur Brennweite der vertikal kollimierenden Linse. Die Wellenlängeneinengung und -stabilisierung kann nach dem Stand der Technik durch interne oder externe wellenlängenselektive Elemente bzw. Strukturen erreicht werden.

Externe Wellenlängeneinengung und -stabilisierung wird durch spektral selektive Rückkopplung der emittierten Strahlung in den Diodenlaser erreicht. Ein Beispiel hierfür sind sog. External-Cavity-Diodenlaser (ECL), bei denen die Rückkopplung durch die spektral selektive Reflexion an Flächengittern erfolgt. Hierbei werden jedoch nachteilhafterweise zusätzliche optische Elemente benötigt und eine Miniaturisierung erschwert.

Eine weitere Möglichkeit der spektral selektiven Rückkopplung sind Volumen-Bragg-Gitter. Durch den Einsatz derartiger Volumen-Bragg-Gitter können vorteilhafterweise kompakte, wellenlängenstabilisierte Laserstrahlquellen realisiert werden.

Es ist beispielsweise aus US 2005/0207466 A1, US 2006/0251143 A1, US 7,298,771 B2, US 7,397,837 B2 und US 7,545,844 B2 bekannt, ein ebenes Volumen-Bragg-Gitter in den vertikal kollimierten oder vertikal und lateral kollimierten Strahl einzubringen.

Es ist alternativ möglich, ein ebenes Volumen-Bragg-Gitter in den divergenten Strahl vor dem Fast-Axis-Kollimator einzubringen und die vertikale und laterale Kollimation erst nach Transmission der Strahlung durch das Volumen-Bragg-Gitter durchzuführen, wie ebenfalls aus US 2005/0207466 A1, US 2006/0251143 A1, US 7,298,771 B2, US 7,397,837 B2 und US 7,545,844 B2 bekannt ist.

Darüber hinaus ist aus US 2005/0248819 A1 bekannt, die vertikal kollimierende Zylinderlinse (also den Fast-Axis-Kollimator) selbst aus dem Volumen-Bragg-Gitter zu fertigen, so dass ein einzelnes optisches Element entsteht, das sowohl die vertikale Kollimation der transmittierenden Strahlung bewirkt als auch spektral selektiv rückkoppelt.

Aus WO 2008/107823 A1 sind augensichere Laseranordnungen mit einem kollimierenden Volumen-Bragg-Gitter als externes frequenzselektives Element in Kombination mit einem dahinter angeordneten Diffusor bekannt. Durch den Diffusor wird die erzeugte Strahlung inkohärent. Durch einen hinter dem Diffusor angeordneten Konzentrator kann das inkohärente Streulicht anschließend parallelisiert werden.

Die WO 2010/022925 A1 offenbart ein System mit ein- oder zweidimensionalen Reihen von Strahlungsquellen, wobei die Strahlungsquellen als stabile oder instabile Resonatoren ausgeführt sind, mit einer optischen Anordnung zur Strahlformung der von den Strahlenquellen abgegebenen Strahlung und mindestens einem spektralen Filter, wobei die optische Anordnung zur Strahlformung sowohl an die Geometrie des Resonators und die Winkel- und Ortsverteilung der Strahlenquellen als auch an die Beugungsverteilung des mindestens einen spektralen Filters angepasst wird.

Die Positionierung des Volumen-Bragg-Gitters hinter der vertikal kollimierenden Linse verfehlt nachteilhafterweise das Ziel eines kurzen Abstandes des Gitters zur Emissionsfläche (nachfolgend auch als Austrittsfacette des Diodenlasers bezeichnet) aufgrund der unvermeidlichen axialen Ausdehnung der vertikal kollimierenden Linse. Das nahe Heranführen des Volumen-Bragg-Gitters an die Emissionsfläche hat sich aber als wesentlich für einen rauscharmen Betrieb des Diodenlasers herausgestellt.

Wird das Volumen-Bragg-Gitter zwischen die Emissionsfläche und die vertikal kollimierende Linse positioniert, kann zwar ein kurzer Abstand zwischen Emissionsfläche und Gitter und damit ein rauscharmen Betrieb erreicht werden. Der vertikale Strahldurchmesser des kollimierten Strahls ist jedoch in diesem Falle durch die axialen Abmessungen des Volumen-Bragg-Gitters und der vertikal kollimierenden Linse nach unten begrenzt. Da die axialen Abmessung des Gitters aus funktionellen und die der Linse aus fertigungstechnischen Gründen eine untere Grenze nicht unterschreiten kann, ergibt sich nachteilhafterweise eine nicht vernachlässigbare Mindestgröße für den vertikalen Durchmesser des kollimierten Strahls.

Führt man das Volumen-Bragg-Gitter selbst als einzelne vertikal kollimierende Linse aus, muss der gewünschte, geringe Abstand des Gitters zur Emissionsfläche mit dem hinteren Brennweitenabstand (back focal length) der Gitter-Linsen-Einheit übereinstimmen. Für eine korrekte Kollimation muss die Gitter-Linsen- Einheit im hinteren Brennweitenabstand zur Emissionsfläche positioniert werden. Aufgrund von Fertigungstoleranzen unterliegt der hintere Brennweitenabstand jedoch Schwankungen, die deutlich größer sein können, als der gewünschte Abstand des Gitters zur Emissionsfläche. Insbesondere kann der hintere Brennweitenabstand negativ werden, so dass keine Kollimation mehr möglich ist.

Zusammenfassend ist es mit keiner der oben genannten Methoden und Vorrichtungen möglich, einerseits das Volumen-Bragg-Gitter zur Realisierung eines rauscharmen Betriebs möglichst nahe an die Emissionsfläche und andererseits die vertikal kollimierenden Linse zur Realisierung eines ausreichend geringen vertikalen Durchmessers möglichst nahe an die Emissionsfläche heranzuführen. Insbesondere kann bei der Verwendung zweier Komponenten (ebenes Volumen-Bragg-Gitter und Zylinderlinse) jeweils eine der Komponenten nicht ausreichend nahe an die Emissionsfläche herangeführt werden. Bei Verwendung eines einzelnen optischen Elements, das Zylinderlinse und Volumen-Bragg-Gitter vereint, führen die vorhandenen Fertigungstoleranzen bei der Forderung eines sehr geringen vertikalen Strahldurchmessers dazu, dass der hintere Brennweitenabstand negativ werden kann, so dass keine Kollimation mehr möglich ist.

Die Aufgabe der Erfindung besteht demnach darin, einen Diodenlaser mit Wellenlängenstabilisierung und vertikaler Kollimation der emittierten Strahlung anzugeben, der einen geringen Abstand des Volumen-Bragg-Gitters zur Emissionsfläche, einen kleinen vertikalen Durchmesser des kollimierten Strahls und außerdem einen Ausgleich von Fertigungstoleranzen bei der Form des Gitters und der Linse ermöglicht.

Diese Aufgabe wird durch die Merkmale des Patentanspruchs 1 gelöst. Bevorzugte Ausgestaltungen sind in den Unteransprüchen enthalten.

Es wurde gefunden, dass durch die Aufteilung der vertikalen Kollimation auf ein Volumen-Bragg-Gitter und eine vertikal kollimierende Linse ein geringer vertikaler Strahldurchmesser des kollimierten Strahls und ein geringer Abstand des Volumen-Bragg-Gitters zur Emissionsfläche erreicht werden kann, wobei Fertigungstoleranzen bei der Formgebung des Volumen-Bragg-Gitters und der vertikal kollimierende Linse vorteilhafterweise durch Anpassen der axialen Position der vertikal kollimierenden Linse ausgeglichen werden können.

Mit anderen Worten werden anstatt eines ebenen Volumen-Bragg-Gitters und einer vertikal kollimierende Linse ein Volumen-Bragg-Gitter mit fokussierender Wirkung und eine vertikal kollimierende Linse verwendet. Das heißt, dass sowohl das Volumen-Bragg-Gitter als auch die nachfolgende vertikal kollimierende Linse eine vertikal fokussierende Wirkung besitzen. Daher kann die Brechkraft vorteilhafterweise auf mehrere Elemente aufgeteilt werden.

Der Vorteil gegenüber der Verwendung eines ebenen Volumen-Bragg-Gitters und einer Zylinderlinse besteht darin, dass sowohl das Volumen-Bragg-Gitter zur Realisierung eines rauscharmen Betriebs als die erste vertikal kollimierenden Linse (das Volumen-Bragg-Gitter) zur Realisierung eines ausreichend geringen vertikalen Durchmessers sehr nahe an die Emissionsfläche herangeführt werden können. Da das Volumen-Bragg-Gitter selbst vertikal kollimiert, kann ein geringerer vertikaler Strahldurchmesser realisiert werden.

Der Vorteil gegenüber der Verwendung eines einzelnen optischen Elements, das Zylinderlinse und Volumen-Bragg-Gitter vereint, besteht darin, dass die notwendige Brechkraft auf zwei optische Elemente aufgeteilt werden kann, wodurch einerseits eine höhere Strahlqualität realisierbar (bessere Unterdrückung von Aberrationen durch Verwendung zweier optischer Elemente) und andererseits größere Bauteiltoleranzen zulässig sind.

Der erfindungsgemäße Diodenlaser weist eine aktive Schicht mit einer Austrittsfacette; ein externes frequenzselektives Element zur Wellenlängenstabilisierung der austretenden Strahlung auf, wobei das externe frequenzselektive Element eine der Austrittsfacette zugewandte Eintrittsfläche und eine der Austrittsfacette abgewandte Austrittsfläche aufweist und als ein Volumen-Bragg-Gitter ausgebildet ist; wobei der erfindungsgemäße Diodenlaser weiterhin eine separate Kollimationseinheit zur Kollimation der aus der Austrittsfacette austretenden und das externe frequenzselektive Element divergent passierenden Laserstrahlung aufweist; wobei das externe frequenzselektive Element zwischen der Kollimationseinheit und der Austrittsfacette angeordnet ist, und wobei die Eintrittsfläche und/oder die Austrittsfläche des externen frequenzselektiven Elements derart ausgebildet sind, dass die Divergenz der aus der Austrittsfacette austretenden Laserstrahlung beim Hindurchtreten durch das externe frequenzselektive Element verringert wird.

Vorzugsweise sind die Eintrittsfläche und/oder die Austrittsfacette des externen frequenzselektiven Elements als nicht-planare Fläche ausgebildet. Dabei können die Eintrittsfläche und/oder die Austrittsfacette vorzugsweise als zylindrische oder azylindrische Flächen ausgebildet werden. Da die Brechkraft nun sowohl auf das externe frequenzselektive Element als auch auf die separate, hinter dem externen frequenzselektiven Element angeordnete vertikal kollimierenden Linse aufgeteilt wird, können die Krümmungsradien der beiden optischen Elemente (externes frequenzselektives Element = 1. Linse und separate vertikal kollimierenden Linse = 2. Linse) größer sein. Ein weiterer Vorteil besteht darin, dass Fertigungstoleranzen bei der Formgebung des Volumen-Bragg-Gitters (externes frequenzselektives Element) und der vertikal kollimierende Linse (Kollimationseinheit) vorteilhafterweise durch Anpassen der axialen Position der vertikal kollimierenden Linse ausgeglichen werden können. Zwischen dem Volumen-Bragg-Gitter (externes frequenzselektives Element) und der vertikal kollimierenden Linse (Kollimationseinheit) befindet sich kein weiteres optisches Element. Vorzugsweise befindet sich zwischen dem Volumen-Bragg-Gitter (externes frequenzselektives Element) und der vertikal kollimierende Linse (Kollimationseinheit) Luft.

Das Verhältnis der Brechkraft des externen frequenzselektiven Elements zur Brechkraft der Kollimationseinheit beträgt zwischen 0.1 und 10, bevorzugter zwischen 0.5 und 2, noch bevorzugter zwischen 0.7 und 1.5, noch bevorzugter zwischen 0.85 und 1.2 und bevorzugter 1.

Vorzugsweise ist die Kollimationseinheit als Zylinderlinse ausgebildet. Vorzugsweise ist mindestens eine Fläche der Kollimationseinheit und des frequenzselektiven Elements zur Verringerung von Aberrationen als nicht-planare azylindrische Fläche ausgebildet. Vorzugsweise beträgt der Abstand zwischen der Austrittsfacette des Diodenlasers und der Eintrittsfläche des externen frequenzselektiven Elements zwischen 10 µm und 500 µm, bevorzugter zwischen 15 µm und 100 µm und noch bevorzugter zwischen 20 µm und 50µm. Vorzugsweise ist der erfindungsgemäße Diodenlaser als Kantenemitter ausgebildet.

Die Erfindung wird nachfolgend anhand eines in der Figur näher dargestellten bevorzugten Ausführungsbeispiels näher erläutert.

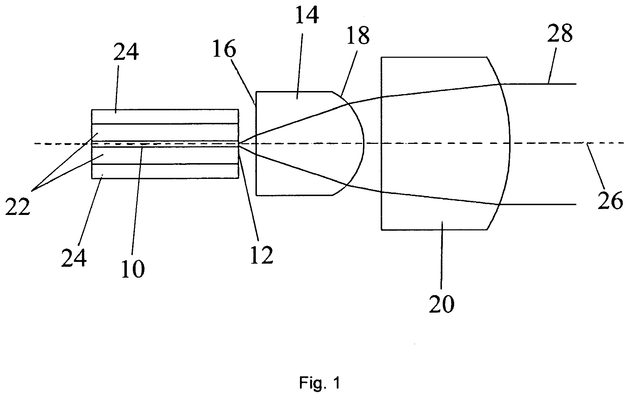

- Fig. 1: zeigt eine einen erfindungsgemäßen Diodenlaser in schematischer geschnittener Darstellung.

Der erfindungsgemäße Diodenlaser der Fig. 1 weist eine aktive Schicht 10 mit einer Austrittsfacette 12 und ein externes frequenzselektives Element 14 zur Wellenlängenstabilisierung der Laserstrahlung auf, wobei das externe frequenzselektive Element 14 als Volumen-Bragg-Gitter ausgebildet ist und eine der Austrittsfacette 12 des Diodenlasers zugewandte Eintrittsfläche 16 und eine der Austrittsfacette 12 des Diodenlasers abgewandte Austrittsfläche 18 aufweist. Weiterhin weist der Diodenlaser eine Kollimationseinheit 20 zur Kollimation der aus der Austrittsfacette 12 austretenden und das externe frequenzselektive Element 14 divergent passierenden Laserstrahlung auf, wobei das externe frequenzselektive Element 14 zwischen der Kollimationseinheit 20 und der Austrittsfacette 12 angeordnet ist. Erfindungsgemäß ist das externe frequenzselektive Element 14 derart ausgebildet, dass die Divergenz der aus der Austrittsfacette 12 austretenden Strahlung beim Passieren des externen frequenzselektiven Elements 14 verringert wird.

Durch die Aufteilung der vertikalen Kollimation auf ein Volumen-Bragg-Gitter und eine vertikal kollimierende Linse kann ein geringer vertikaler Strahldurchmesser des kollimierten Strahls und ein geringer Abstand des Volumen-Bragg-Gitters zur Emissionsfläche erreicht werden, wobei Fertigungstoleranzen bei der Formgebung des Volumen-Bragg-Gitters und der vertikal kollimierende Linse vorteilhafterweise durch Anpassen der axialen Position der vertikal kollimierenden Linse ausgeglichen werden können.

Es wird daher erfindungsgemäß anstatt eines ebenen Volumen-Bragg-Gitters und einer vertikal kollimierende Linse ein Volumen-Bragg-Gitter mit fokussierender Wirkung und eine vertikal kollimierende Linse verwendet. Das heißt, dass sowohl das Volumen-Bragg-Gitter als auch die nachfolgende vertikal kollimierende Linse eine vertikal fokussierende Wirkung besitzen. Daher kann die Brechkraft vorteilhafterweise auf mehrere Elemente aufgeteilt werden.

## Patentansprüche

1. Diodenlaser, aufweisend:
eine aktive Schicht (10) mit einer Austrittsfacette (12);
ein externes frequenzselektives Element (14) ausgebildet zur Wellenlängenstabilisierung
der Laserstrahlung, wobei das externe frequenzselektive Element (14) eine der Austrittsfacette (12) zugewandte Eintrittsfläche (16) und eine der Austrittsfacette (12) abgewandte Austrittsfläche (18) aufweist und durch ein Volumen-Bragg-Gitter ausgebildet ist; und
eine separate Kollimationseinheit (20) ausgebildet zur Kollimation der aus der
Austrittsfacette (12) austretenden und das externe frequenzselektive Element (14) divergent passierenden Laserstrahlung;
wobei das externe frequenzselektive Element (14) zwischen der Kollimationseinheit (20) und der Austrittsfacette (12) angeordnet ist, sich zwischen dem externen frequenzselektiven Element (14) und der Kollimationseinheit (20) kein weiteres optisches Element befindet, und das externe frequenzselektive Element (14) derart ausgebildet ist, dass die Divergenz der aus der Austrittsfacette (12) austretenden Strahlung beim Passieren des externen frequenzselektiven Elements (14) verringert wird;
**dadurch gekennzeichnet, dass**
das Verhältnis der Brechkraft des externen frequenzselektiven Elements (14) zur Brechkraft der Kollimationseinheit (20) zwischen 0.1 und 10 beträgt.

2. Diodenlaser nach Anspruch 1,
**dadurch gekennzeichnet, dass**
die Eintrittsfläche (16) und/oder die Austrittsfacette (12) des externen frequenzselektiven Elements (14) als nicht-planare Fläche ausgebildet sind.

3. Diodenlaser nach einem der vorhergehenden Ansprüche,
**dadurch gekennzeichnet, dass**
die Eintrittsfläche (16) und/oder die Austrittsfacette (12) des externen frequenzselektiven Elements (14) als geschlossene, gekrümmte Fläche ausgebildet sind.

4. Diodenlaser nach einem der vorhergehenden Ansprüche,
**dadurch gekennzeichnet, dass**
das Verhältnis der Brechkraft des externen frequenzselektiven Elements (14) zur Brechkraft der Kollimationseinheit (20) zwischen 0.5 und 2 beträgt.

5. Diodenlaser nach einem der vorhergehenden Ansprüche,
**dadurch gekennzeichnet, dass**
die Kollimationseinheit (20) als Zylinderlinse ausgebildet ist.

6. Diodenlaser nach Anspruch 5,
**dadurch gekennzeichnet, dass**
mindestens eine Fläche der Kollimationseinheit (20) und des frequenzselektiven Elements (14) zur Verringerung von Aberrationen als nicht-planare azylindrische Fläche ausgebildet ist.

7. Diodenlaser nach einem der vorhergehenden Ansprüche,
**dadurch gekennzeichnet, dass**
der Abstand zwischen der Austrittsfacette (12) und der Eintrittsfläche (16) des externen frequenzselektiven Elements (14) zwischen 15 µm und 100 µm beträgt.

8. Diodenlaser nach einem der vorhergehenden Ansprüche,
**dadurch gekennzeichnet, dass**
der Diodenlaser als Kantenemitter ausgebildet ist.

## Claims

1. A laser diode, including:
an active layer (10) with an exit facet (12);
an external frequency-selective element (14) designed for wavelength stabilization of the laser radiation,
wherein the external frequency-selective element (14) has an entrance surface (16) facing the exit facet (12) and an exit surface (18) facing away from the exit facet (12) and is formed by a volume Bragg grating; and
a separate collimating unit (20) designed for collimating the laser radiation which exits the exit facet (12) and divergently passes through the external frequency-selective element (14);
wherein the external frequency-selective element (14) is arranged between the collimating unit (20) and the exit facet (12), no further optical element is located between the external frequency-selective element (14) and the collimating unit (20), and the external frequency-selective element (14) is designed such that the divergence of the radiation exiting from the exit facet (12) is reduced when its passes through the external frequency-selective element (14);
**characterized in that**
the ratio of the refractive power of the external frequency-selective element (14) to the refractive power of the collimating unit (20) is between 0.1 and 10.

2. The laser diode according to Claim 1,
**characterized in that**
the entrance surface (16) and/or the exit facet (12) of the external frequency-selective element (14) are designed as a non-planar surface.

3. The laser diode according to any one of the preceding claims, **characterized in that**
the entrance surface (16) and/or the exit facet (12) of the external frequency-selective element (14) are designed as a closed, curved surface.

4. The laser diode according to any one of the preceding claims, **characterized in that**
the ratio of the refractive power of the external frequency-selective element (14) to the refractive power of the collimating unit (20) is between 0.5 and 2.

5. The laser diode according to any one of the preceding claims, **characterized in that**
the collimating unit (20) is designed as a cylinder lens.

6. The laser diode according to Claim 5,
**characterized in that**
at least one surface of the collimating unit (20) and of the frequency-selective element (14) is designed as a non-planar acylindrical surface to reduce aberrations.

7. The laser diode according to any one of the preceding claims, **characterized in that**
the distance between the exit facet (12) and the entrance surface (16) of the external frequency-selective element (14) is between 15 µm and 100 µm.

8. The laser diode according to any one of the preceding claims, **characterized in that**
the laser diode is designed as an edge emitter.

## Revendications

1. Laser à diodes, comportant :
une couche active (10) comprenant une facette de sortie (12) ;
un élément externe sélectif en fréquence (14) conçu pour la stabilisation de la longueur d'ondes du rayonnement laser, l'élément externe sélectif en fréquence (14) comportant une surface d'entrée (16) orientée vers la facette de sortie (12) et un surface de sortie (18) orientée dans la direction opposée à la facette de sortie (12) et étant formé par un réseau de Bragg en volume ; et
un ensemble de collimation (20) séparé conçu pour la collimation du rayonnement laser sortant par la facette de sortie (12) et traversant l'élément externe sélectif en fréquence (14) de manière divergente ;
l'élément externe sélectif en fréquence (14) étant disposé entre l'ensemble de collimation (20) et la facette de sortie (12), aucun autre élément optique ne se trouvant entre l'élément externe sélectif en fréquence (14) et l'ensemble de collimation (20), et l'élément externe sélectif en fréquence (14) étant conçu de telle manière que la divergence du rayonnement sortant par la facette de sortie (12) est diminuée lors de la traversée de l'élément externe sélectif en fréquence (14) ;
**caractérisé en ce que**
le rapport du pouvoir réfringent de l'élément externe sélectif en fréquence (14) au pouvoir réfringent de l'ensemble de collimation (20) est compris entre 0,1 et 10.

2. Laser à diodes selon la revendication 1,
**caractérisé en ce que**
la surface d'entrée (16) et/ou la facette de sortie (12) de l'élément externe sélectif en fréquence (14) sont réalisées sous la forme d'une surface non plane.

3. Laser à diodes selon l'une quelconque des revendications précédentes, **caractérisé en ce que**
la surface d'entrée (16) et/ou la facette de sortie (12) de l'élément externe sélectif en fréquence (14) sont réalisées sous la forme d'une surface incurvée fermée.

4. Laser à diodes selon l'une quelconque des revendications précédentes, **caractérisé en ce que**
le rapport du pouvoir réfringent de l'élément externe sélectif en fréquence (14) au pouvoir réfringent de l'ensemble de collimation (20) est compris entre 0,5 et 2.

5. Laser à diodes selon l'une quelconque des revendications précédentes, **caractérisé en ce que**
l'ensemble de collimation (20) est réalisé sous la forme d'une lentille cylindrique.

6. Laser à diodes selon la revendication 5,
**caractérisé en ce que**
au moins une surface de l'ensemble de collimation (20) et de l'élément sélectif en fréquence (14) est conçue sous la forme d'une surface non cylindrique non plane pour réduire les aberrations.

7. Laser à diodes selon l'une quelconque des revendications précédentes, **caractérisé en ce que**
la distance entre la facette de sortie (12) et la surface d'entrée (16) de l'élément externe sélectif en fréquence (14) est comprise entre 15 µm et 100 µm.

8. Laser à diodes selon l'une quelconque des revendications précédentes, **caractérisé en ce que**
le laser à diodes est réalisé sous la forme d'un émetteur latéral.
